# EUROPEAN PATENT SPECIFICATION

(11) **EP 0 808 020 B1**
(45) Date of publication and mention of the grant of the patent: **01.08.2001**
(21) Application number: 97107837.3
(22) Date of filing: 14.05.1997
(51) Int. Cl.: H03J 1/00

(54) **An automatic channel selection device**
Automatische Kanalauswahlvorrichtung
Dispositif de sélection automatique de canal

(30) Priority: 17.05.1996 JP 12295696
(43) Date of publication of application: 19.11.1997
(73) Proprietor: MATSUSHITA ELECTRIC INDUSTRIAL CO., LTD., Kadoma-shi, Osaka 571-0050 (JP)
(72) Inventor: Takeshima, Yuri, Takatsuki-shi, Osaka 569-11 (JP)
(74) Representative: Kügele, Bernhard

(56) References cited:
- DE-A- 3 928 176
- GB-A- 2 208 458
- PATENT ABSTRACTS OF JAPAN vol. 006, no. 028 (E-095), 19 February 1982 & JP 56 147514 A (CLARION CO LTD), 16 November 1981,

## Description

### BACKGROUND OF THE INVENTION

This invention relates to an automatic channel selection device of electronic tuner having a function setting the preset channel automatically. As shown in the Japanese Patent Publication Sho 56-147514, the device or system designed to perform the automatic channel presetting work had employed a method by which the channel selection work was made at a base of one-by-one channel or at a base of every channel pushing a memory or preset selector button manually. However, this was drastically improved, and developed was a device searching sequentially the plural broadcasting channels automatically for the channels having intensity levels above the predetermined level, and the data obtained of the channels were stored in the memory.

However, even with this improved automatic channel selection system or device, the presetting work of automatic channel selection device had to be started manually by the user of device, that is, the user of device had to judge the necessity of presetting work by himself before starting this manual presetting work, and this series of work had to be started upon finding the necessity of this.

Since the above described manual procedure had to be carried out for every newly purchased television receiver, and this had been quite unfamiliar work for the receiver purchaser despite it was one of the very first operations and an essential work obeying to the supplied instruction and manual. Moreover, since these essential works had required the judgments and works for the users of AV equipments, these had been troublesome works, and had been problems to be corrected.

The document GB-A-2 208 458 describes an autoprogramming tuner apparatus which can automatically scan available channels and program a memory device with data relating to the active channels found during the scan. The autoprogramming is carried out after a power failure of the receiver and is triggered by the switching on of the receiver.

### SUMMARY OF THE INVENTION

The object of the present invention is to solve the above-described problems and to offer an automatic channel selection device requiring no judgment on the presetting works nor no actual preset works before starting the operation of automatic channel selection device. That is, according to the invented automatic channel selection device, a memory content judge-and-process means by which the content and the condition of memory storing the data of channel selection are checked and the necessity of presetting work of automatic channel selection is judged, is provided, and the automatic channel selection work is started if the necessity of channel presetting work is confirmed, memorizing the obtained channel selection data in the memory.

Since the invented automatic channel selection device is employed as an essential television channel selection device performing the above-described presetting work automatically, the judging and operating work which are highly troublesome to users are eliminated contributing much to the improvement of television operability.

### BRIEF DESCRIPTION OF THE DRAWINGS

Fig. 1 shows a block diagram of the invented automatic channel selection device which is an embodiment of the invention.

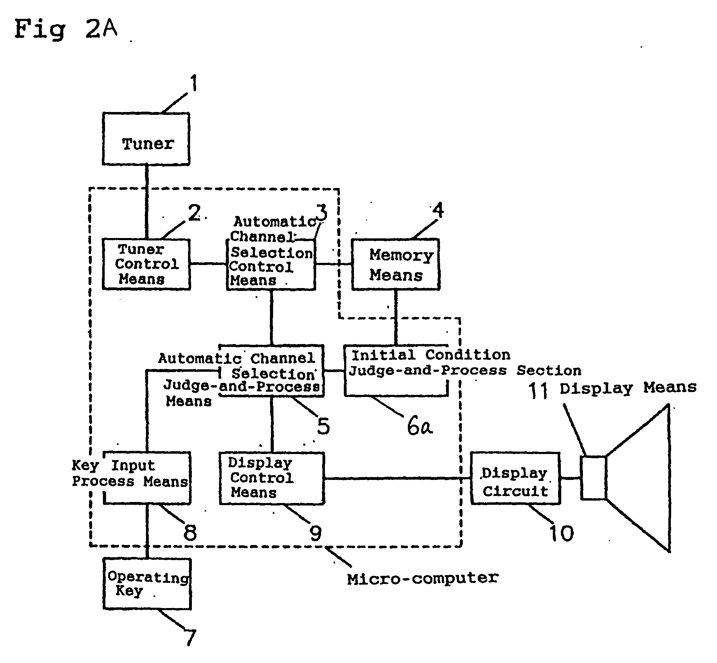

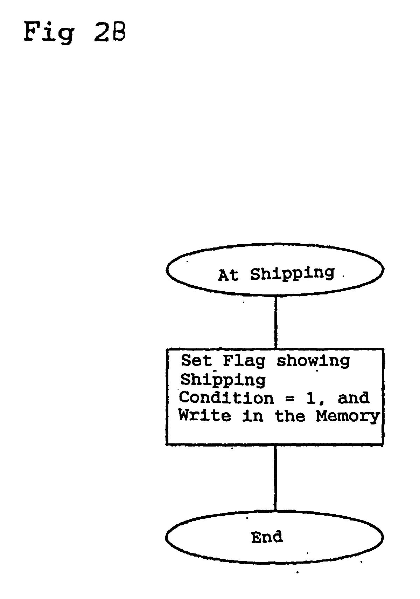

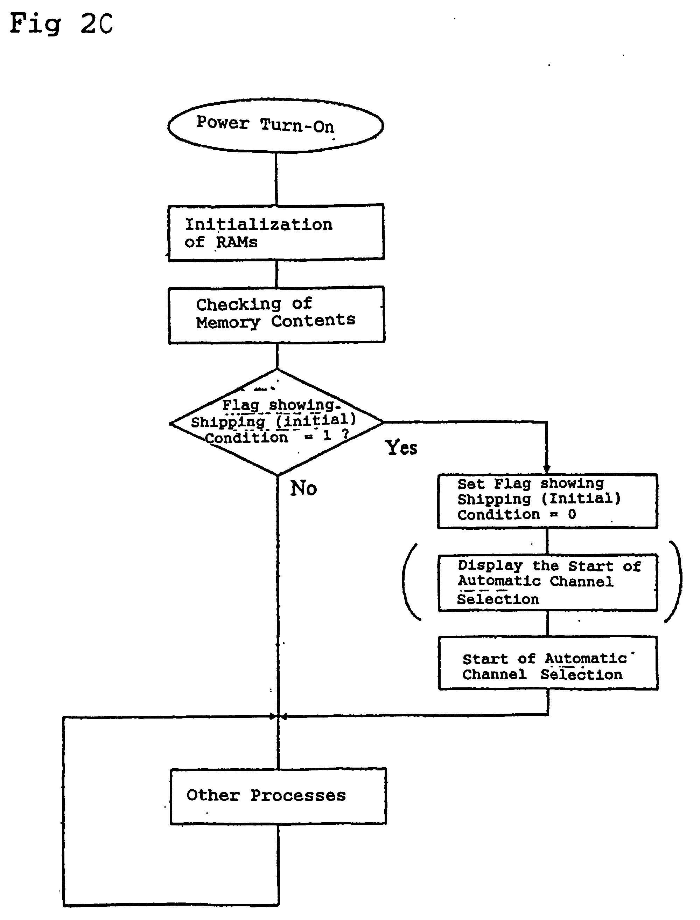

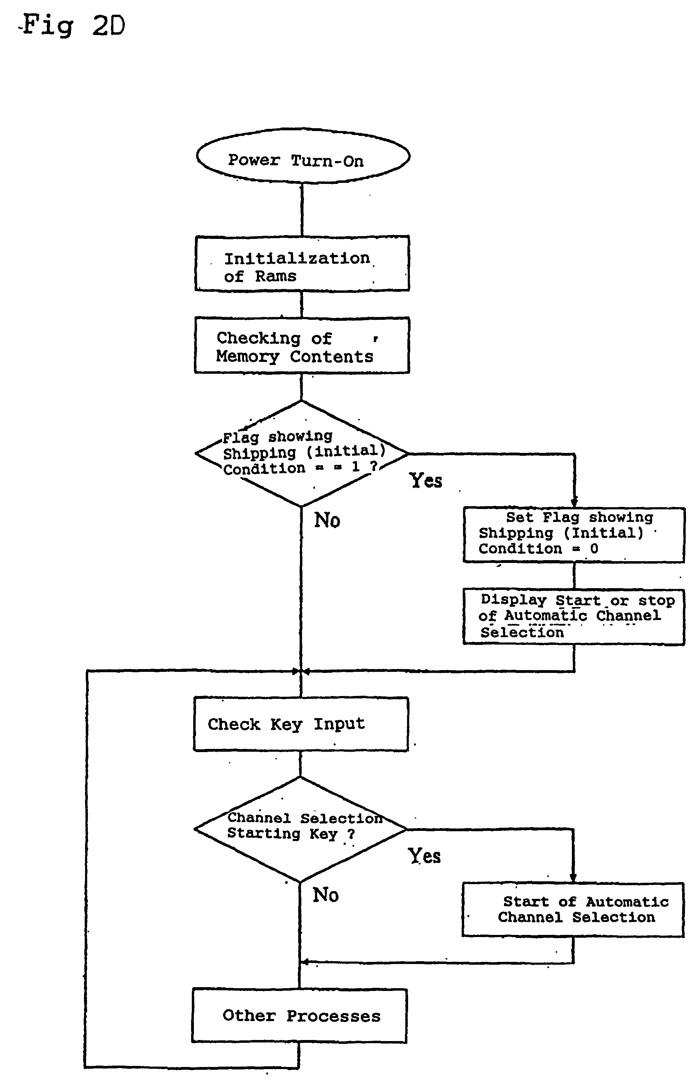

Fig. 2A shows a block diagram of the invented automatic channel selection device which is an embodiment of the invention applied to a television receiver, Fig. 2B shows a flow-chart of the automatic channel selection device which is an embodiment of the invention and is developed to memorize an initial or shipping condition of television receiver in a memory, Fig. 2C shows a flow-chart of the automatic channel selection device which is an embodiment of the invention explaining a process to start the automatic channel selection work upon detecting an initial or shipping condition of television receiver, and Fig. 2D shows a flow-chart of the automatic channel selection device which is an embodiment of the invention showing an instruction of keying operation which is related to an automatic channel selection work to a device operator confirming the displays on television receiver.

Fig. 3 shows another block diagram of the automatic channel selection device which is another embodiment of the invention applied to a television receiver.

Fig. 4 shows a block diagram of the automatic channel selection device which is another embodiment of the invention, and is applied to a television receiver.

Fig. 5 shows a block diagram of the automatic channel selection device which is still another embodiment of the invention and is applied to television receiver.

### DESCRIPTION OF THE PREFERRED EMBODIMENTS

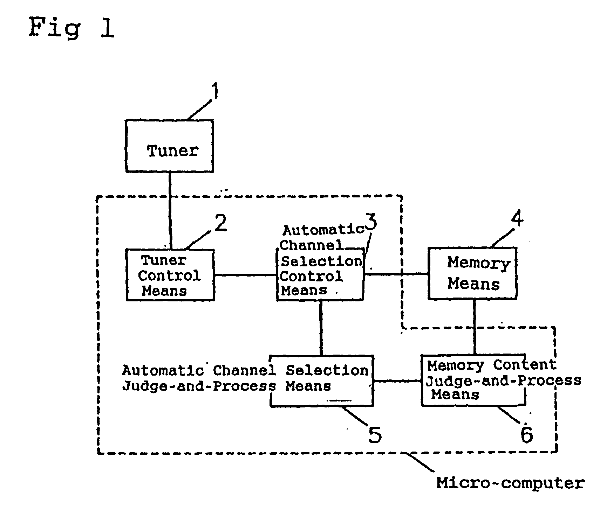

A preferred embodiment of the invention is now shown in Fig. 1 wherein electronic tuner 1 detects and inputs a signal having a frequency corresponding to that of tuning voltage supplied by tuner control means 2, tuner control means 2 generates said tuning voltage by a control signal supplied from automatic channel selection control means 3 and supplies this to electronic tuner 1.

Said automatic channel selection control means 3 reads one of the channel selection data memorized in memory means 4, and supplies a control signal to tuner control means 2 so that a channel signal corresponding to the information of data could be received by electronic tuner 1.

In this case, said channel selection data corresponding to each of the channels which can be received at the location of purchased television (which could be different depending on local city, area, etc) should be sequentially stored in memory means 4 instead of data previously stored in there (normally, a series of this work is called "preset").

Memory content judge-and-process means 6 which is an important constituting element of the invention is connected to said memory means 4, and said memory content judge-and-process means 6 determines the content and the condition of said memory means 4. For instance, those contents identifying its initial condition, abnormal points, any information possibly erased by user, etc. are informed to automatic channel selection judge-and-process means 5.

Then, said automatic channel selection judge-and-process means 5 instructs an automatic channel selection work to said automatic control means 3 depending on the result of judgement made by said memory content judge-and-process means 6 identifying above-said contents and conditions, and said automatic channel selection control means 3 starts the automatic channel selection work on a base of one-by-one channel through said tuner control means 2 and said electronic tuner 1, and those obtained channel selection data are stored in said memory means 4, completing the automatic preset work thus.

Among those above-shown constituting elements, the area encircled by a broken line in Fig. 1 shows that those within the area are executable by means of micro-computer.

Fig, 2A shows an embodiment of the invention where the invented automatic channel selection device is applied to a television receiver, and shows a case of initial condition judge-and-process which should be processed by said memory content judge-and-process means shown in Fig. 1.

In Fig. 2A, explanations about the constituent elements which are same as in Fig. 1 are omitted. The initial condition judge-and-process part 6a included in said memory content judge means 6 shown in Fig. 1 judges the content of said memory means 4 in order to determine if it is an initial condition or not, and if it is so, this is informed to automatic channel selection control means 5.

As shown in an embodiment shown in Fig. 1, said automatic channel selection judge-and-process means 5 instructs said automatic channel selection control means 3 to start the automatic channel selection work beside telling the user (TV viewer) to show that the content of display means 11 is in an initial condition and showing this on display means 11 such as CRT through display control means 9 and display circuit 10. Recognizing this display on said display means 11, the user may input an instruction which is related to said automatic channel selection judge-and-process means 5 through said key input process means 8 by using operating key 7.

Figs. 2B, 2C and 2D show flow-charts of programs which are related to respective embodiments of the invention wherein these processes are performed by a micro-computer. First of all, as shown in Fig. 2B, flag of the micro computer showing that a newly manufactured television receiver is in a shipping (initial) condition is set at 1, and this is written in the memory before it is shipped out.

When a consumer (user) purchased and installed this television at his home and turn on its power switch for example, the micro-computer incorporated therein conducts an initialization work of the memory RAMs as shown in Fig. 2C, and checks the contents in these memories. After automatically confirming the flag condition showing its shipping (initial) condition which should be either "1" or "0", if the flag is in a condition of "1" or initial condition, this flag is rewritten in 0, and the operation of automatic channel selection is started by using said automatic control means 3, and at the same time, the information with regard to the automatic channel selection operation is displayed on display 11 shown in Fig. 2A.

On the other hand, if the flag is in "0" showing that this is no shipping (initial) condition, another process can be performed. The flow-chart shown in Fig. 2D shows a case where the user inputs an instruction which is related to the channel selection through the operation key. That is, if the flag shows a shipping (initial) condition of "1", the flag is rewritten into "0", and this is shown on display means 11, and the instruction for starting the automatic channel selection work is displayed. Recognizing these displays on the display screen, the user inputs the channel selection instruction through the key.

The micro-computer checks these inputs and judges whether if the key input of channel selection start is made or not, and the automatic channel selection is started if it is confirmed.

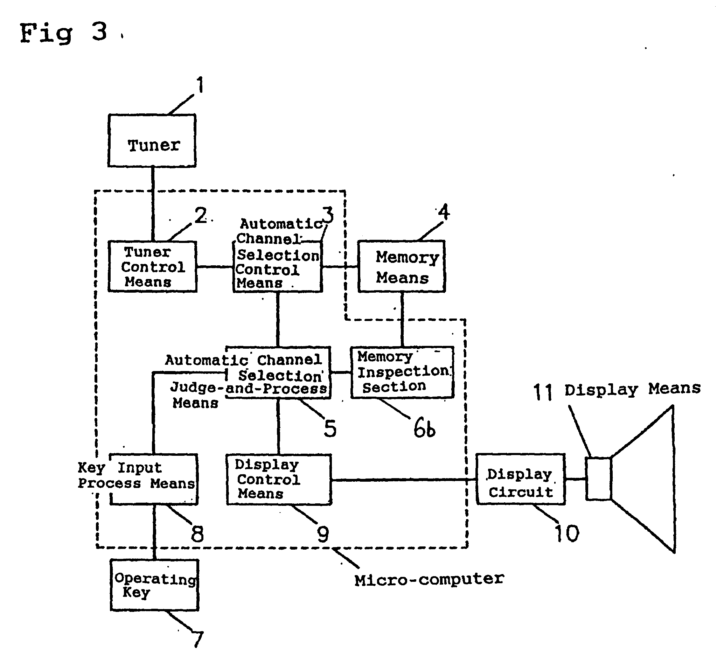

Figs. 3, 4 and 5 show still another block diagrams of the invented automatic channel selection device, obtained when this is applied to television receiver. In these diagrams, the explanations of the elements which are same as those in Figs. 1 and 2 are omitted or simplified.

Fig. 3 shows a case where the inspection of memory contents is performed by said memory content judge-and-process means 6 shown in Fig. 1. In Fig. 3, memory content inspecting part 6b included in said (in Fig. 1) memory content judge-and-process means 6 checks the content of memory means 4 for any damages therein. If damages are confirmed, this fact is informed to said automatic channel selection judge-and-process means 5.

In this case, like the previous case, automatic channel selection judge-and-process means 5 instructs a start of automatic channel selection work to automatic channel selection control means 3, and at the same time, displays the automatic channel selection related information on display means 11 through display control means 9 and display circuit 10.

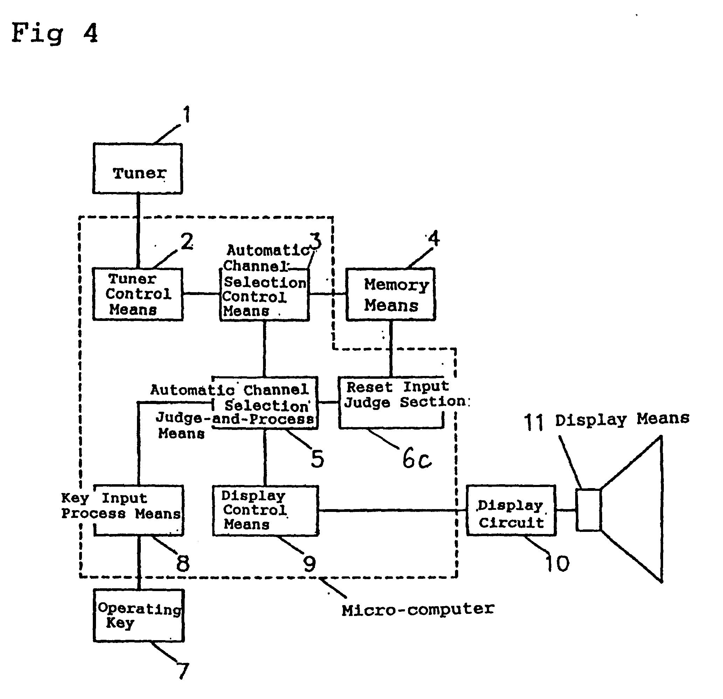

Fig. 4 shows a case where said memory content judge-and-process means 6 shown in Fig. 1 confirms the start of memory means 4 from the reset condition and proceeds to the next process.

That is, in Fig. 4, memory content inspecting part 6b included in said (Fig. 1) memory content judge-and-process means 6 judges the start of memory means 4 from its reset condition. If the reset condition is recognized, this fact is informed to said automatic channel selection judge-and-process means 5. By this, said automatic channel selection judge-and-process means 5 instructs a start of automatic channel selection work to automatic channel selection control means 3, and at the same time, displays the automatic channel selection related information on display means 11 through display control means 9 and display circuit 10.

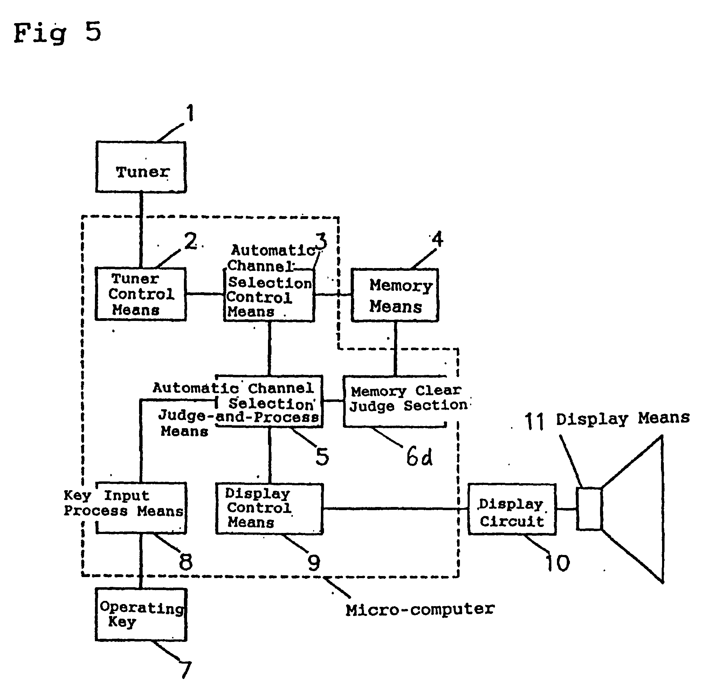

Fig. 5 shows a case where said memory content judge-and-process means 6 shown in Fig. 1 judges the channel selection data which are preset and stored in memory means 4 for any erase by the user, and proceeds to the next step. That is, in Fig. 6, said (Fig. 1) memory clear judge part 6d included in said memory content judge-and-process means 6, judges the preset channel selection data stored in memory means 4 for any damage by the user. If any erased condition is recognized, this fact is informed to automatic channel selection judge-and-process means 5.

Confirming the receive of this signal, said automatic channel selection judge-and-process means 5 instructs a start of automatic channel selection work to said automatic channel selection control means 3, and at the same time, displays the automatic channel selection related information on said display means 11 through display control means 9 and display circuit 10.

As above described, the invented automatic channel selection device checks the contents and the conditions of memory which stores each of the channel selection data by using the memory content judge-and-process means. If a condition of the presetting work start for channel selection is found, the automatic preset of all channels can be started. Thus, this contributes very highly to the improvement of operability of channel selection device.

Moreover, although the attached drawings show several embodiments of the invention which are obtained by means of micro-computer, it is evident that this can be done by using a device consisted of discrete components. In addition to these, the chan nel selection system can not be limited within a systems employing a frequency synthesizer nor a voltage synthesizer. As above explained, this invention can not be limited within the embodiments shown above, and plural other embodiments are possible also, so that the present invention should be limited only by the appended claims.

## Claims

1. An automatic channel selection device comprising:
an electronic tuner (1),
a tuner control means (2) controlling said electronic tuner (1),
an automatic channel selection control means (3) controlling said automatic tuner control means (2) to start automatic channel selection,
a memory means (4) exchanging tuning data within said automatic channel selection control means (3), and
an automatic channel selection judge-and-process means (5) connected to said automatic channel selection control means (3),
characterised in that the automatic channel selection device further comprises
a memory content judge-and-process means (6) connected to said memory means (4) checking the condition and the content of said memory means, and connected to said automatic channel selection judge-and-process means (5) which instructs said automatic channel selection control means (3) to control said automatic channel selection according to the checked result of conducted by said memory content judge-and-process means (6).

2. An automatic channel selecting device according to Claim 1; wherein said memory content judge-and-process means checks the content memorized in said memory means for the initial condition, and the result of this check is transmitted to said automatic channel selection judge-and-process means.

3. An automatic channel selecting device according to Claim 1; wherein said memory content judge-and-process means checks the content memorized in said memory means for any abnormality, and the result of this check is transmitted to said automatic channel selection judge-and-process means.

4. An automatic channel selecting device according to Claim 1; wherein said memory content judge-and-process means checks said memory means for the starting from the reset condition of said memory means, and the result of this check is transmitted to said auto matic channel selection judge-and-process means.

5. An automatic channel selecting device according to Claim 1; wherein said memory content judge-and-process means checks said memory means for any erase of data stored in said memory means by user, the result of this check is transmitted to said automatic channel selection judge-and-process means.

6. An automatic channel selection judge-and-process means according to Claims 1, 2, 3, 4, and 5 equipped with a display means displaying the data related to said judgement results obtained from said memory content judge-and-process means.

7. An automatic channel selection judge-and-process means according to Claim 6, able to receive the channel selection related instructions inputted through key board operation after confirming information displayed on said display means, and able to instruct said automatic channel selection control means to control the automatic channel selection.

## Patentansprüche

1. Automatische Kanalauswahlvorrichtung mit:
einem elektronischen Abstimmgerät (1),
einem das benannte elektronische Abstimmgerät (1) steuernden Abstimmsteuerorgan (2),
einem automatischen Kanalauswahlsteuerorgan. (3), das das benannte automatische Abstimmsteuerorgan (2) steuert, um die automatische Kanalauswahl zu beginnen,
einem Speicherorgan (4), das Abstimmdaten innerhalb des benannten automatischen Kanalauswahlsteuerorgans (3) austauscht, und
einem an das benannte automatische Kanalauswahlsteuerorgan (3) angeschlossenen Organs (5) zur automatischen Kanalauswahlbeurteilung und -verarbeitung,
dadurch gekennzeichnet, dass die automatische Kanalauswahlvorrichtung weiter umfasst:
ein an das benannte Speicherorgan (4) angeschlossenes Organ (6) zur Speicherinhaltsbeurteilung und -verarbeitung, das den Zustand und den Inhalt des benannten Speicherorgans überprüft, ebenfalls angeschlossen an das benannte Organ (5) zur automatischen Kanalauswahlbeurteilung und -verarbeitung, das das benannte automatische Kanalauswahlsteuerorgan (3) anweist, die benannte automatische Kanalauswahl je nach dem Ergebnis der Überprüfung durch das benannte Organ (6) zur Speicherinhaltsbeurteilung und -verarbeitung zu steuern.

2. Automatische Kanalauswahlvorrichtung nach Anspruch 1, worin das benannte Organ zur Speicherinhaltsbeurteilung und -verarbeitung den in dem benannten Speicherorgan gespeicherten Inhalt auf den Anfangszustand hin überprüft und das Ergebnis dieser Überprüfung an das benannte Organ zur automatischen Kanalauswahlbeurteilung und -verarbeitung übermittelt.

3. Automatische Kanalauswahlvorrichtung nach Anspruch 1, worin das benannte Organ zur Speicherinhaltsbeurteilung und -verarbeitung den in dem benannten Speicherorgan gespeicherten Inhalt auf mögliche Unregelmässigkeiten hin überprüft und das Ergebnis dieser Überprüfung an das benannte Organ zur automatischen Kanalauswahlbeurteilung und -verarbeitung übermittelt.

4. Automatische Kanalauswahlvorrichtung nach Anspruch 1, worin das benannte Organ zur Speicherinhaltsbeurteilung und -verarbeitung das benannte Speicherorgan auf den Start des benannten Speicherorgans aus dem Rückstellzustand hin überprüft und das Ergebnis dieser Überprüfung an das benannte Organ zur automatischen Kanalauswahlbeurteilung und -verarbeitung übermittelt.

5. Automatische Kanalauswahlvorrichtung nach Anspruch 1, worin das benannte Organ zur Speicherinhaltsbeurteilung und -verarbeitung das benannte Speicherorgan auf mögliche Löschung von in dem benannten Speicherorgan gespeicherten Daten durch den Benutzer hin überprüft und das Ergebnis dieser Überprüfung an das benannte Organ zur automatischen Kanalauswahlbeurteilung und -verarbeitung übermittelt.

6. Organ zur automatischen Kanalauswahlbeurteilung und -verarbeitung nach Ansprüchen 1, 2, 3, 4 und 5, ausgerüstet mit einem Anzeigeorgan, das die Daten anzeigt, die sich auf die benannten Beurteilungsergebnisse beziehen, die von dem benannten Organ zur Speicherinhaltsbeurteilung und -verarbeitung erhalten wurden.

7. Organ zur automatischen Kanalauswahlbeurteilung und -verarbeitung nach Anspruch 6, in der Lage, die durch Tastenfeldbedienung eingegebenen, auf Kanalauswahl bezogenen Befehle zu empfangen, nachdem auf dem benannten Anzeigeorgan angezeigte Information bestätigt wurde, und in der Lage, das benannte automatische Kanalauswahisteuerorgan anzuweisen, die automatische Kanalauswahl zu steuern.

## Revendications

1. Dispositif de sélection automatique de canaux comprenant :
un syntoniseur électronique (1),
un moyen de commande de syntoniseur (2) commandant ledit syntoniseur électronique (1),
un moyen de commande de sélection automatique de canaux (3) qui commande ledit moyen de commande de syntoniseur automatique (2) afin de lancer la sélection de canaux automatique,
un moyen de mémoire (4) échangeant des données d'accord à l'intérieur dudit moyen de commande de sélection automatique de canaux (3), et
un moyen d'évaluation et de traitement de sélection automatique de canaux (5) relié audit moyen de commande de sélection automatique de canaux (3),
caractérisé en ce que le dispositif de sélection automatique de canaux comprend en outre
un moyen d'évaluation et de traitement de contenu de mémoire (6) relié audit moyen de mémoire (4) qui,contrôle l'état et le contenu dudit moyen de mémoire, et relié audit moyen d'évaluation et de traitement de sélection automatique de canaux (5) qui donne pour instruction audit moyen de commande de sélection automatique de canaux (3) de commander ladite sélection de canaux automatique conformément au résultat contrôlé exécuté par ledit moyen d'évaluation et de traitement de contenu de mémoire (6).

2. Dispositif de sélection automatique de canaux selon la revendication 1, dans lequel ledit moyen d'évaluation et de traitement de contenu de mémoire contrôle le contenu mémorisé dans ledit moyen de mémoire pour rechercher un état initial, et le résultat de ce contrôle est transmis audit moyen d'évaluation et de traitement de sélection automatique de canaux.

3. Dispositif de sélection automatique de canaux selon la revendication 1, dans lequel ledit moyen d'évaluation et de traitement de contenu de mémoire contrôle le contenu mémorisé dans ledit moyen de mémoire pour rechercher une anomalie quelconque, et le résultat de ce contrôle est transmis audit moyen d'évaluation et de traitement de sélection automatique de canaux.

4. Dispositif de sélection automatique de canaux selon la revendication 1, dans lequel ledit moyen d'évaluation et de traitement de contenu de mémoire contrôle ledit moyen de mémoire pour rechercher le début en partant de l'état réinitialisé dudit moyen de mémoire, et le résultat de ce contrôle est transmis audit moyen d'évaluation et de traitement de sélection automatique de canaux.

5. Dispositif de sélection automatique de canaux selon la revendication 1, dans lequel ledit moyen d'évaluation et de traitement de contenu de mémoire contrôle ledit moyen de mémoire pour rechercher un effacement quelconque des données mémorisées dans ledit moyen de mémoire par l'utilisateur, le résultat de ce contrôle est transmis audit moyen d'évaluation et de traitement de sélection automatique de canaux.

6. Moyen d'évaluation et de traitement de sélection automatique de canaux selon les revendications 1, 2, 3, 4 et 5 muni d'un moyen d'affichage affichant les données associées auxdits résultats d'évaluation obtenus à partir dudit moyen d'évaluation et de traitement de contenu de mémoire.

7. Moyen d'évaluation et de traitement de sélection automatique de canaux selon la revendication 6, permettant de recevoir des instructions associées à une sélection de canaux reçues en entrée par l'intermédiaire d'un actionnement d'un clavier après avoir confirmé des informations affichées sur ledit moyen d'affichage, et permettant de donner pour instruction audit moyen de commande de sélection automatique de canaux de commander la sélection de canaux automatique.
